# EUROPEAN PATENT APPLICATION

(11) **EP 1 109 215 A2**
(43) Date of publication of application: **20.06.2001**
(21) Application number: 00126574.3
(22) Date of filing: 12.12.2000
(51) Int. Cl.: H01L 21/66, H01L 21/60

(54) **Apparatus and method for solder bump inspection**

(30) Priority: 16.12.1999 JP 35773499
(71) Applicant: SHINKO ELECTRIC INDUSTRIES CO. LTD., Nagano-shi, Nagano 380-0921 (JP)
(72) Inventor: Murayama, Kei, Shinko Electric Ind. Co., Ltd., Nagano-shi, Nagano 380-0921 (JP); Higashi, Mitsutoshi, Shinko Electric Ind. Co. Ltd., Nagano-shi, Nagano 380-0921 (JP)
(74) Representative: Schmidt, Steffen J., Dipl.-Ing.

(57) **Abstract**

A bump inspection apparatus for inspecting shapes of a plurality of bumps each having a planar top portion, on an inspection object, comprising an illumination optical system for illuminating the top portions with a vertical parallel pencil of light through a telecentric optical system, an observation optical system using a telecentric optical system having an optical axis thereof in conformity with that of the illumination optical system, an observation portion for observing the images of the top portions through the observation optical system in a predetermined range of the inspection object, and a processing portion for analyzing the shapes of the bumps on the basis of the images of the top portions by the observation portion, wherein the processing portion includes analyzing means for analyzing the areas of the planar top portions for the individual bumps and judging means for judging whether or not the rears of the top portions are within a predetermined range. A bump inspection method using this apparatus is described, too.

## Description

### BACKGROUND OF THE INVENTION

### 1. Field of the Invention

This invention relates to a bump inspection apparatus. More particularly, this invention relates to a bump inspection apparatus for inspecting shapes, heights, etc, of bumps formed as connection terminals on a BGA substrate, or the like, and a bump inspection apparatus.

### 2. Description of the Related Art

Semiconductor devices using flip-chip (FC) technologies include those semiconductor devices in which hemispherical bumps are formed as FC connection terminals at lands formed on a substrate surface. The bumps can be shaped when a solder ball is bonded to each land. In semiconductor devices in which the bumps have a small diameter and are disposed in a high density, however, it is customary to supply a solder paste to the lands by a printing method and to form hemispherical bumps by reflow of the solder.

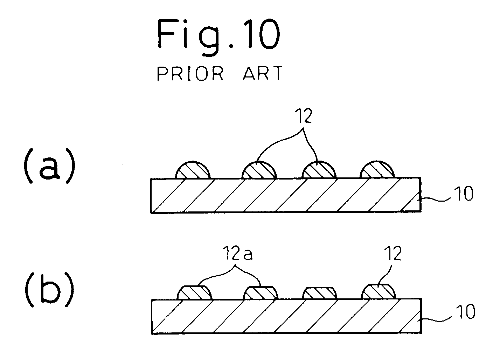

Fig. 10(a) of the accompanying drawings shows the state where a solder paste is supplied to a substrate 10 and is heated to form the bumps 12 on the surface of the substrate 10. To shape the bumps 12 by using the solder paste in this way, a coining process is conducted on the top portions of the bumps 12 so as to planarize the top portions of the bumps 12 into a planar surface 12a. This coining process is conducted by using a coining jig having a flat pushing surface so that the bumps 12 can be collectively coined and all the bumps 12 have a uniform height. Fig. 10(b) shows the state where the bumps 12 are coined. The portions of the planar surface 12a are formed by a coining function as connection end faces that are to be connected to electrodes of a packaging substrate.

The bumps 12 are coined in order to align the height of the connection end faces of the bumps when the bumps 12 themselves are variable in height, or when the connection end faces of the bumps 12 are variable in height over the substrate as a whole due to a deformation of the substrate, such as a warp, to secure a predetermined contact area for the connection end faces of the bumps, and to reliably bond the bumps to the packaging substrate. To allow the planar surfaces 12a as the connection end faces to secure a predetermined contact area is of importance particularly when the size of the bumps is small.

Variation in bump height results from variation in the amount of the solder paste supplied to the individual lands and variation in the quantity of the flux contained in the solder paste. Variation in the amount of the solder paste renders no problem at all in the case of the bumps having a height of hundreds of microns and used for conventional substrates. When small bumps having a height of dozens of microns, however, even a slight variation in the solder paste greatly affects the height and shapes of the bumps. When the bumps are small, therefore, it becomes difficult to accurately shape the bumps. The small bumps typically have a height of about 40 µm ± 15 µm, which will be reduced to about 20 to 30 µm by coining.

When the bumps are small, variation in the height of the bumps exerts a relatively large influences when the solder paste is supplied to the lands and the bumps are formed, as described above. For this reason, it is necessary to inspect the coined state to determine whether or not the bumps are shaped into a predetermined shape. When the bumps are shaped into the hemispherical shape with a height lower than a predetermined height, the coining amount becomes small, and the connection end faces of the bumps cannot secure a predetermined area. When the bumps are shaped to be higher than the predetermined height, on the contrary, the coining amount becomes great and the area of the connection end faces of the bumps becomes excessively large.

A simple method of inspecting the shapes of the bumps is the one that images the substrate surface having the bumps formed thereon using a CCD camera, and detects the shapes of the individual bumps, particularly the planar surface of the top portion of the bumps. Each bump 12 is shaped so that its top is the planar surface 12a and its side surface is curved as shown in Fig. 10(b). Therefore, if the boundary position between the planar surface 12a of the bump and its side surface can be clearly observed, the area, etc, of the planar surface 12a can be detected. When this observation is conducted by the CCD camera through an ordinary optical system, however, the contrast of the boundary portion between the planar surface 12a and the side surface of the bump 12 becomes obscure, and the planar surface 12 cannot be distinctively observed. Furthermore, accurate measurement becomes difficult because the images of the bumps 12 at the peripheral portions of the image reception area of the CCD camera are distorted.

### SUMMARY OF THE INVENTION

It is therefore an object of the present invention to provide a bump inspection apparatus and method that can observe, very accurately, the connection end faces of bumps, by utilizing optical means, in an inspection object equipped with bumps formed by using a solder paste, each having a planar connection end face formed by coining the bump, at the top thereof, and can easily provide an approval/rejection judgment of the shapes of the bumps.

To accomplish the object described above, the present invention provides a bump inspection apparatus for inspecting shapes of a plurality of bumps each having a planar top portion, on an inspection object, comprising an illumination optical system for providing a parallel pencil of light vertical to the top portions through a telecentric optical system; an observation optical system comprising a telecentric optical system having an optical axis thereof in conformity with that of the illumination optical system; an observation portion for observing the images of the top portions in a predetermined range of the inspection object through the observation optical system; and a processor unit for analyzing the shapes of the bumps on the basis of the images of the top portions by the observation portion; wherein the processor unit includes analyzing means for analyzing the area of the planar top portion of each of the bumps, and judging means for judging whether or not the area of the top portion falls within a predetermined range.

Preferably, the top portions of all the bumps of the inspection object exist on the same plane.

Preferably, the bumps are formed into a substantially hemispherical shape by reflowing of solder, and the top portions of the bumps are shaped into a planar shape by a coining process.

According to another aspect of the present invention, there is provided a bump inspection method for inspecting the shapes of a plurality of bumps each having a planar top portion, on an inspection object, comprising the steps of: an illumination step of providing a vertical parallel pencil of light to the top portions through a telecentric optical system; an observation step of observing by a telecentric optical system having an optical axis in conformity with that of the illumination optical system; another observation step of observing the images of the top portions within a predetermined range of the inspection object through the observation optical system; and a processing step of analyzing the shapes of the bumps on the basis of the images of the top portions by the observation portion; wherein the processing step includes an analyzing stage of analyzing the areas of the planar top portions for the individual bumps and a judging stage of judging whether or not the areas of the top portions are within a predetermined range.

Preferably, the top portions of all the bumps of the inspection object exist on the same plane.

Preferably, each bump is shaped into a substantially hemispherical shape by reflowing of solder, and the top portion is shaped into a planar shape by a coining processing.

The observation optical system receives only the reflected rays of light vertical to the planar surface of the top portion of each bump among the reflected rays of light, from the inspection object, of illumination light projected by the illumination optical system to the inspection object. In consequence, the observation portion can catch the shapes of the planar surfaces as distinct images, and the shapes of the bumps can be correctly inspected by the analysis done by a processing unit.

When the inspection object is the products shaped in such a fashion that the planar surfaces of all the bumps exist on the same plane, approval/rejection of the products can be correctly judged when the shapes of the planar surfaces are correctly detected.

When the bumps are shaped into a substantially hemispherical shape by reflowing of solder and are then coined to process their top portions into the planar surfaces, variation in the height of the bumps appears relatively greatly, and variation in luster of the bumps, etc, may occur. According to the apparatus of the present invention, however, the shapes of the bumps can be correctly inspected.

The processing unit described above includes analyzing means for analyzing the area of each planar surface and judging means for judging whether or not the area of the planar surface falls within a predetermined range. Therefore, when the area of the planar surface is analyzed, approval/rejection of the products can be judged by appropriately judging the shapes of the bumps through the analysis of the area of the planar surface.

### BRIEF DESCRIPTION OF THE DRAWINGS

Fig. 1 shows an overall construction of a bump inspection apparatus according to the present invention;
Fig. 2 shows a construction of a comparative example of a bump inspection apparatus;
Fig. 3 shows a construction of another comparative example of a bump inspection apparatus;
Fig. 4 shows a state where bumps are observed by using a bump inspection apparatus according to the present invention;
Fig. 5 shows a state where bumps are observed by using a bump inspection apparatus of a comparative example;
Fig. 6 shows an inspection example where bumps are observed by using a bump inspection apparatus according to the present invention;
Fig. 7 shows an inspection example where bumps are observed by using a bump inspection apparatus according to the present invention;
Fig. 8 shows the change of height of bumps before and after a coining processing;
Fig. 9 shows a method of coining bumps having different height; and
Fig. 10 shows the state of bumps before and after a coining processing.

### DESCRIPTION OF THE PREFERRED EMBODIMENTS

Hereinafter, preferred embodiments of the present invention will be explained in detail with reference to the accompanying drawings.

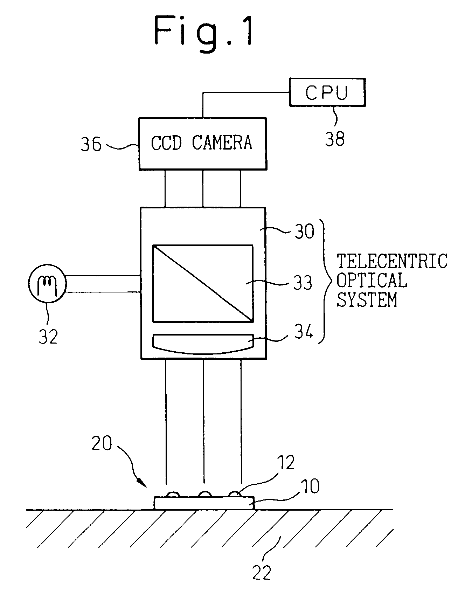

Fig. 1 is an explanatory view showing an overall construction of a bump inspection apparatus according to the present invention. In the drawing, reference numeral 20 denotes an inspection object having bumps formed on one of the surfaces of a substrate 10 in the region in which a semiconductor chip is flip-chip-bonded to the substrate 10. The bumps 12 are formed by supplying a solder paste to lands formed on the surface of the substrate 10 by a printing method, causing reflowing of the solder paste to form hemispherical bumps 12 and then coining the tops of the bumps 12 to a planar surface. Reference numeral 22 denotes a stage that supports the inspection object 20.

Reference numeral 30 denotes an optical system portion including an illumination optical system for irradiating illumination light as a parallel pencil of rays from a light source 32 to the inspection object 20, and an observation optical system disposed with an optical axis thereof in conformity with that of the illumination optical system. Reference numeral 33 denotes a half-mirror and reference numeral 34 denotes a collimating lens. This optical system portion 30 constitutes a telecentric optical system. Illumination light from the light source 32 is irradiated to the inspection object 20 through the telecentric optical system, and reflected rays of light from the inspection object 20 are observed by an observation optical system of the telecentric optical system.

The inspection object 20 is disposed on the stage 22 in such a fashion that its substrate surface is perpendicular to the axes of the illumination optical system and the observation optical system of the optical system portion 20. Consequently, the reflected rays of light from the inspected object 20 are converged by the observation optical system, and a CCD camera 36 as an observation portion forms images of the bumps 12 on the substrate 10.

The telecentric optical system used for the observation optical system is an optical system in which all the main rays of light travel in parallel with the axis in an object space or an image space. Even when an error exists in setting of the object surface or in the image surface, this optical system can minimize the error of the size of the image to be imaged. Therefore, this optical system is utilized for measuring dimensions of objects. According to this telecentric optical system, only the reflected rays of light parallel to the optical axis of the observation optical system, among the rays of light illuminated by the illumination optical system and scattered from the inspection object 20, are converged and received by the CCD camera 36.

The CCD camera receives the reflected rays of light parallel to the optical axis of the observation optical system among the rays of light reflected by the inspection object 20. In the bump inspection apparatus according to this embodiment, therefore, the CCD camera 36 forms the images of the reflected rays of light from the planar surface 12a formed on the bumps 12 of the inspection object 20. The top of each bump 12 is coined into the planar surface 12a and has the vertical positional relation with the optical axis of the observation optical system as described above. The rays of illumination light projected vertically to the substrate surface of the inspection object 20 (stage 22) are reflected from the planar surface 12a parallel to the optical axis of the observation optical system. On the other hand, the rays of light illuminated to the side surface of the bump 12 are not reflected parallel to the optical axis of the observation optical system. Therefore, these rays of light are not received by the observation optical system and are not received by the CCD camera 36, either.

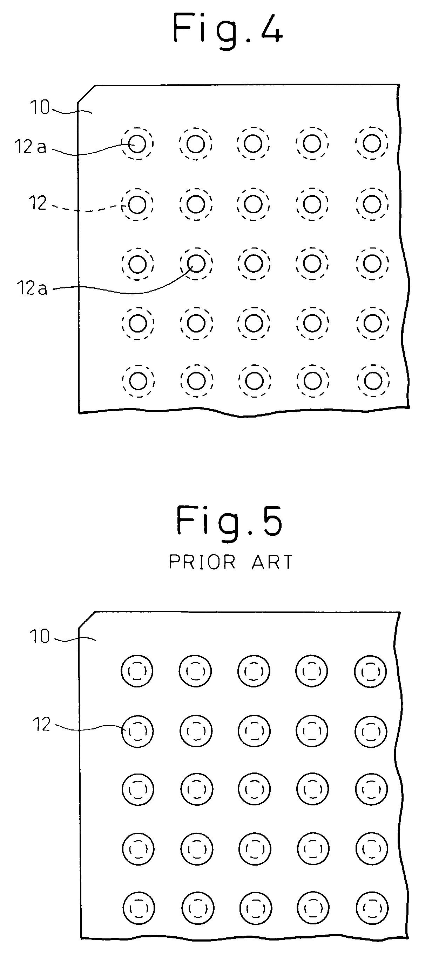

Fig. 4 shows, explanatorily, the state where the CCD camera 36 images the bumps 12. According to the inspection apparatus having this construction, the images caught by the CCD camera 36 are the image of the planar surface 12a formed at the top of each bump 12.

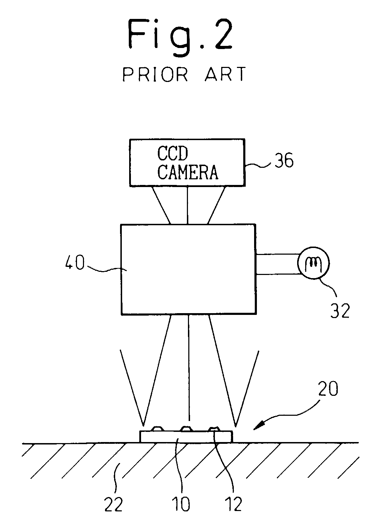

Fig. 2 shows an example of an inspection apparatus using an optical system having an angle of field in the observation optical system as a comparative example of the bump inspection apparatus according to the present invention. Reference numeral 40 denotes an optical system that irradiates illumination light from the light source 32 to the inspection object 20 and converges the reflected rays of light from the inspection body 20.

Fig. 5 shows, explanatorily, the state where this inspection apparatus observes the bumps. The optical system of this inspection apparatus receives the reflected rays of light obliquely incident to the observation optical system besides the reflected rays of light that are parallel to the optical system.
Therefore, the optical system receives the reflected rays of light from the side surface of the bumps in addition to the reflected rays of light from the planar surface 12a of the bumps 12, so that the image of the CCD camera 36 has a low contrast of the images of the bumps 12 as a whole, and the planar surface 12a cannot be observed distinctly.

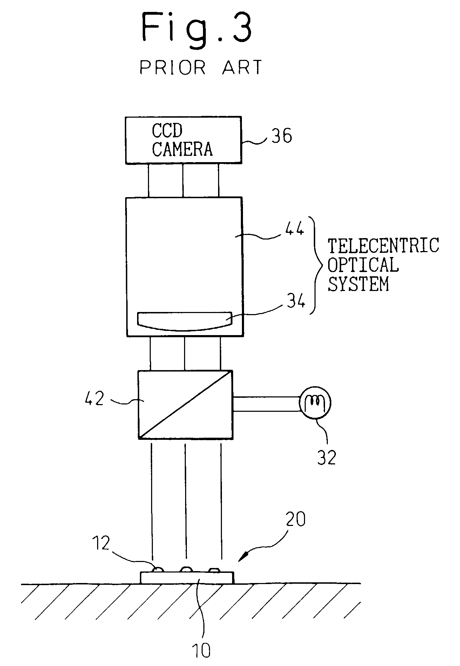

As another comparative example of the bump inspection apparatus, Fig. 3 shows the state where the rays of light do not travel through the telecentric optical system as the illumination optical system. Reference numeral 42 denotes a half mirror, and reference numeral 44 denotes a converging optical system comprising a telecentric optical system.

In this bump inspection apparatus, too, the rays of illumination light projected to the inspection object 20 are not completely parallel pencils of light. Therefore, this bump inspection apparatus cannot clearly observe those objects having concavo-convexities such as the inspection object 20 having the bumps 12 formed on the surface of the substrate 10, or those having low contrast.

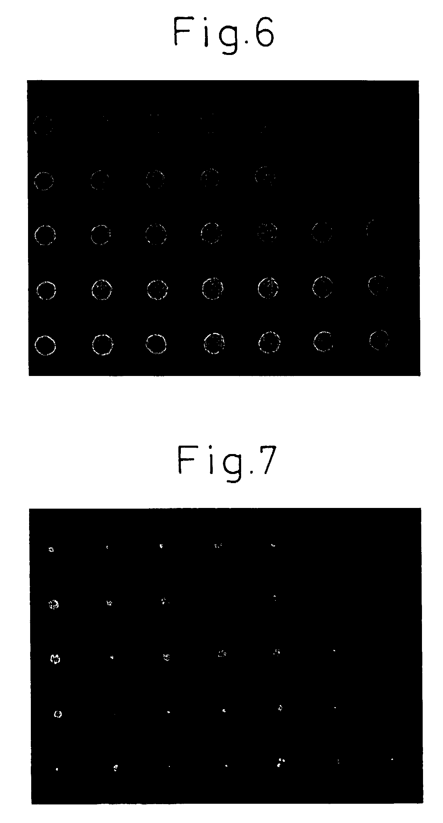

Figs. 6 and 7 show the inspection results when the CCD camera 36 practically images the inspection object 20 having the bumps 12 formed on the surface of the substrate 10 by using the bump inspection apparatus according to the present invention.

The bumps shown in Figs. 6 and 7 have a bump height of 50 ± 15 µm before coining and 30 ± 10 µm after coining. In the example shown in Fig. 6, the diameter of the planar surface of the bumps is from 120 µm to 150 µm, and in the example shown in Fig. 7, the diameter is from 0 to 50 µm.

In the drawings, circular dot portions represent the images of the planar surface 12a of the bumps 12. In the inspection example shown in Fig. 6, the individual bumps 12 are coined substantially uniformly. In contrast, the areas of the planar surfaces 12a (crush amounts) of the bumps 12 are smaller and some bumps 12 do not have the planar surfaces 12a in the inspection example shown in Fig. 7. The inspection results shown in Figs. 6 and 7 represent that when the bump inspection apparatus of this embodiment is used, the shapes and the sizes of the planar surfaces 12a of the bumps can be distinctively determined, so that defects, etc, of the bumps 12 can be properly judged.

The reason why the images of the planar surfaces 12a of the bumps 12 can be formed as shown in Figs. 6 and 7 is because the inspection object 20 is illuminated by the telecentric optical system and is observed by the observation optical system by the telecentric optical system.

The reflection factor of the bumps 12 formed by the solder is by far higher than the reflection factor of the substrate 10. Therefore, the CCD camera 36 can form the images of only the planar surface 12a of the bumps with high contrast. Luster of the outer surface may vary to a certain extent and the reflection factor may vary depending on the bumps 12, but no problem occurs at all in the inspection of the planar surface 12a because the contrast is sufficiently high.

Approval/rejection judgment of the bumps 12 is made on the basis of the analysis of the shapes and areas of the planar surfaces 12a of the bumps 12.

To judge approval/rejection from the shapes of the planar surface 12a, the judgment may be made from the shape of the planar surface 12a from the image obtained from the CCD camera 36. When the bumps 12 are shaped into the normal shape, the planar shapes 12a become circular. When the planar shapes 12a are not circular but distorted, it can be estimated that the bumps 12 are shaped into shapes other than a hemispherical shape during the reflow process. When cracks or scratches are observed in the planar surfaces 12a, too, it can be estimated that problems developed during the shaping of the bumps 12. Therefore, products having such bumps 12 are rejected as defective and are inspected again.

The image signals from the CCD camera 36 are inputted to a processing unit 38. The processing unit 38 analyzes the images of the planar surface 12a from the CCD camera 36 and can detect the degree of deformation of the planar surface 12a from the perfect circle, and can thus judge approval/rejection of the shapes of the bumps 12. The processing unit 38 can also detect abnormality of the planar surface 12a of the bumps 12 such as cracks from the images of the CCD camera 36 and can judge approval/rejection of the shapes of the bumps 12.

The measurement of the area of the planar surface 12a has the technical meaning of judging whether or not each bump 12 has a predetermined contact area, and also the technical meaning of judging the size of the bumps 12 before coining and whether or not the bumps are shaped into the normal shape when they are coined.

Whether or not the planar surface 12a of each bump 12 has a predetermined area can be judged by inspecting the image of the planar surface 12a of the individual bump 12 obtained from the CCD camera 36, or by analyzing the area of the planar surface 12a by the processor unit 38. When the planar surfaces 12a have small dot-like shapes and fail to provide predetermined areas as shown in Fig. 7, for example, judgment can be made to reject the product as defective because the predetermined contact area is not provided.

As described above, the bumps 12 are formed on the substrate 10 by supplying the solder paste to the lands by the printing method. In this case, variation occurs unavoidably in the sizes of the bumps 12. Variation in the sizes of the bumps 12 formed on the substrate 10 must fall within a predetermined range. Therefore, the method that measures the areas of the planar surfaces 12a of the bumps 12 can be utilized as a method of estimating the variation in the sizes of the bumps 12.

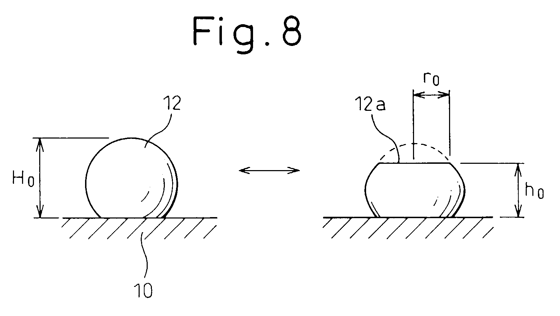

Fig. 8 shows the state where bumps 12 are shaped into a hemispherical shape by supplying the solder paste to the lands and the state where the planar surface 12a is formed on the top of each bump 12 by coining. In the drawing, Hₒ represents the height of the bump 12 before coiling, and hₒ represents the height of the bump 12 after coining. When the radius of the planar surface 12a is rₒ by approximating the planar surface 12a to a circle, the height hₒ after coining of the bump 12 can be approximated to hₒ = Hₒ - rₒ. In other words, Hₒ = hₒ + rₒ. Here, the height hₒ of the bump 12 after coining is the value that is set in advance by a processing machine. Assuming that Hₒ is the design value (standard value) of the height of the bump 12, the standard radius rₒ of the planar surface 12a is determined for the bumps 12 having the standard size when hₒ is set. When the planar surface 12a of a certain bump 12 is measured and its radius r proves the standard radius rₒ, on the contrary, it can be understood that the bump 12 is shaped into the standard (design) size.

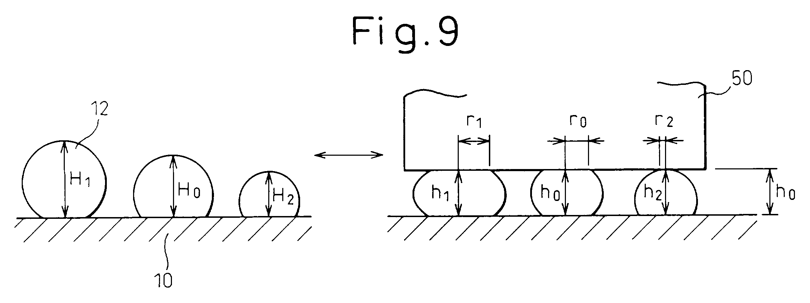

Fig. 9 shows the state where three different kinds of bumps 12 having different height are formed on the substrate 10, and are coined by a coining punch 50. As a result of coining, each bump 12 is processed to the same height ho. Assuming that the radii of the planar surfaces 12a of these bumps 12 after coining are r₁, r₂ and r₃, the relation H₁ = h₁ + r₁ = hₒ + r₁, Hₒ = hₒ + rₒ, and H₂ = h₂ + r₂ = hₒ + r₂ can be established for each bump in the same way as in Fig. 8. In other words, when the radii r₁, r₂ and r₃ of the planar surfaces 12a after coining are measured, the height H₁, Hₒ and H₂ of the bumps 12 before coining can be determined by approximation.

Assuming that the minimum allowance value of the height of the bumps 12 is Hₘᵢₙ and the maximum allowance value is Hₘₐₓ, variation range of the height of the bumps 12 is Hₘᵢₙ ≦ Hₓ ≦ Hₘₐₓ. Similarly, the allowance range is rₘᵢₙ ≦ rₓ ≦ rₘₐₓ for the radius r and Sₘᵢₙ ≦ Sₓ ≦ Sₘₐₓ for the area S of the planar surface 12a.

In other words, when the radius r of the planar surface 12a of the bump 12 or its area S is measured for the inspection object 20 after coining is done, it is possible to judge whether or not the bumps 12 are within the predetermined allowance range, by judging whether or not the measurement value is within the predetermined variation range.

To measure the radius or the area of the planar surface 12a, analyzing means of the processor unit 38 analyzes the image of the planar surface 12a by the CCD camera 36 to determine the radius or the area of the connection end face. A judgment means judges whether or not the value of the radius or area of the analysis result falls within the variation range that is set in advance.

As described above, the CCD camera 36 can distinctively determine the planar surface 12a of the bump 12. When the image analysis is made for all the bumps 12, approval/rejection of the inspection object 20 can be made. In other words, approval/rejection judgment of the inspection object 20 can be made by the analysis of the area of the planar surface 12a of the bump 12.

Incidentally, the substrate itself in the practical inspection object 20 has concavo-convexities or is warped to a certain extent, and the individual substrates have variation of the thickness, too. These variations function as the error in measurement accuracy of the planar surface 12a of the bump 12. However, when variation of the substrates is managed in such a fashion that the variations of warp, etc, of the substrates are smaller than the height of the bumps, the substrates can be managed by the approval/rejection judgment method that judges the bumps according to the condition of the height of the bumps described above, that is Hₘᵢₙ ≦ Hₓ ≦ Hₘₐₓ, can be used without any problem. When the height of the bumps is 40 µm, for example, management is conducted so that the variation quantity of the substrates such as warp is not greater than about 10 µm. When it is necessary to strictly manage the production accuracy, the concavo-convexities and the thickness of the substrates are measured in advance and substrates, the variation of which is within the predetermined variation range, are used.

In the embodiments described above, the explanation has been made on the inspection of the inspection object 20 having the bumps that are formed by supplying the solder paste by the printing method to the lands of the substrate 10. However, the bump inspection apparatus according to the present invention can be similarly applied to, and can inspect approval/rejection of the bumps in, the inspection object having the bumps that are formed into the planar shape so that the connection end face to the mounting surface has uniform height, irrespective of the production method used.

In connection with the substrate, too, the bump inspection apparatus of the present invention can be similarly applied to products the substrate of which is a semiconductor wafer, such as products in which the bumps are formed on the semiconductor wafer, besides products in which solder bumps are formed on a resin substrate such as a BGA substrate.

The bump inspection apparatus according to the present invention particularly uses the telecentric optical system as the observation optical system. Therefore, the observation optical system can observe the images devoid of distortion in the entire image reception range, and can clearly observe the connection end faces. Therefore, it can perform the inspection extremely accurately and efficiently. Furthermore, this observation optical system has the advantage that even when the inspection object is shaped into a mirror shape such as a semiconductor wafer, or when it has a small difference of the reflection factors between the bumps and the substrate, this system can perform reliable inspections.

As described above, the observation optical system in the present invention receives only the reflected rays of light vertical to the planar surface formed at the top of the bumps from among the reflected rays of light from the inspection object and can correctly grasp the shapes of the bumps. Accordingly, the present invention can accurately inspect the shapes of the bumps.

## Claims

1. A bump inspection apparatus for inspecting shapes of a plurality of bumps each having a planar top portion, on an inspection object, comprising:
an illumination optical system for illuminating said top portions with a parallel pencil of light vertical thereto through a telecentric optical system;
an observation optical system comprising a telecentric optical system having an optical axis thereof in conformity with that of said illumination optical system;
an observation portion for observing the images of said top portions in a predetermined range of said inspection object through said observation optical system; and
a processor unit for analyzing the shapes of said bumps on the basis of the images of said top portions from said observation portion;
said processor unit including analyzing means for analyzing the area of said planar top portion of each of said bumps, and judging means for judging whether or not the area of said top portion falls within a predetermined range.

2. A bump inspection apparatus according to claim 1, wherein said top portions of all of said bumps of said inspection object exist on the same plane.

3. A bump inspection apparatus according to claim 2, wherein said bumps are formed into a substantially hemispherical shape by reflowing of solder, and said top portions of said bumps are shaped into a planar shape by a coining process.

4. A bump inspection method for inspecting shapes of a plurality of bumps each having a planar top portion, on an inspection object, comprising the steps of:
an illumination step of illuminating said top portions with a vertical parallel pencil of light vertical thereto through a telecentric optical system;
an observation step of observing by a telecentric optical system having an optical axis in conformity with that of said illumination optical system;
another observation step of observing the images of said top portions within a predetermined range of said inspection object through said observation optical system; and
a processing step of analyzing the shapes of said bumps on the basis of the images of said top portions by said observation portion;
said processing step including an analyzing stage of analyzing the areas of said planar top portions for said individual bumps and a judging stage of judging whether or not the areas of said top portions are within a predetermined range.

5. A bump inspection method according to claim 4, wherein said top portions of all of said bumps of said inspection object exist on the same plane.

6. A bump inspection method according to claim 5, wherein said bump is shaped into a substantially hemispherical shape by reflowing of solder, and said top portion is shaped into a planar shape by a coining processing.
